# EUROPEAN PATENT APPLICATION

(11) **EP 4 741 849 A1**
(43) Date of publication of application: **13.05.2026**
(21) Application number: 25745495.9
(22) Date of filing: 02.01.2025
(51) Int. Cl.: G01R 31/382, G01R 31/396, G01R 31/36, G01R 19/30

(54) **BATTERY DIAGNOSIS APPARATUS AND BATTERY DIAGNOSIS METHOD**

(30) Priority: 25.01.2024 KR 20240011568
(71) Applicant: LG Energy Solution, Ltd., Seoul 07335 (KR)
(72) Inventor: YOO, In-Sun, Daejeon 34122 (KR); BAE, Yoon-Jung, Daejeon 34122 (KR)
(74) Representative: Goddar, Heinz J.
(86) International application number: PCT/KR2025/000039
(87) International publication number: WO 2025/159387

(57) **Abstract**

There are provided a battery diagnosis apparatus and a battery diagnosis method. The battery diagnosis apparatus includes a sensing unit configured to measure a voltage of a battery cell, and a control circuit configured to determine an amount of voltage drop of the battery cell for each rest period based on a voltage measurement signal collected from the sensing unit at least twice every rest period. The control circuit is configured to generate self-discharge history data indicating a change in the amount of voltage drop over the plurality of rest periods. The control circuit is configured to diagnose a self-discharge state of the battery cell based on the self-discharge history data.

## Description

### TECHNICAL FIELD

The present disclosure relates to self-discharge diagnosis in batteries.

This application is based on and claims priority to Korean Patent Application No. 10-2024-0011568 filed on January 25, 2024 in the Republic of Korea, the disclosure of which is incorporated herein by reference.

### BACKGROUND

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly charged and discharged.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

A battery system that requires high voltage and/or large capacity such as an electric vehicle generally includes a plurality of batteries connected either in series or in parallel or both.

In the battery system, a failure in any battery may adversely affect the performance and safety of the entire battery system. Accordingly, in the management of the battery system, it is important to properly detect a failure in the individual batteries.

Among many different types of battery failures, a self-discharge failure relies on a self-discharge factor of the battery. Here, the self-discharge factor may include the amount and speed of voltage drop or a combination thereof.

The self-discharge failure in the battery is generally determined based on voltage values of the battery measured two or more times during rest.

However, failure determination based on the amount of voltage drop in a single rest period results in low accuracy. For example, when there is a temporary error or external noise in the process of measuring the voltage, inaccurate voltage values may be acquired, and the diagnosis result of self-discharge failure based on the voltage values has low reliability.

### DISCLOSURE

### Technical Problem

The present disclosure is designed to solve the above-described problems, and therefore the present disclosure is directed to providing an apparatus and method for diagnosing a self-discharge state of a battery cell by analyzing a change in an amount of voltage drop of the battery cell based on voltage of the battery cell measured over a plurality of rest periods sequentially allocated by periodically or aperiodically stopping the charge/discharge of the battery cell.

These and other objectives and advantages of the present disclosure may be understood from the following description and will become apparent from the embodiments of the present disclosure. Also, it will be easily understood that the objectives and advantages of the present disclosure may be realized by the means set forth in the appended claims and a combination thereof.

### Technical Solution

A battery diagnosis apparatus according to an aspect of the present disclosure includes a sensing unit configured to measure a voltage of a battery cell, and a control circuit configured to determine an amount of voltage drop of the battery cell for each rest period based on a voltage measurement signal collected from the sensing unit at least twice every rest period. The control circuit is configured to generate self-discharge history data indicating a change in the amount of voltage drop over the plurality of rest periods. The control circuit is configured to diagnose a self-discharge state of the battery cell based on the self-discharge history data.

The control circuit may be configured to determine a first risk level arising from an increasing trend of the amount of voltage drop when the increasing trend is identified from the self-discharge history data.

The control circuit may be configured to determine the first risk level according to an intensity of the increasing trend. The control circuit may be configured to generate alarm information for warning the first risk level.

The control circuit may be configured to determine a second risk level arising from a decreasing trend of the amount of voltage drop when the decreasing trend is identified from the self-discharge history data.

The control circuit may be configured to determine the second risk level according to an intensity of the decreasing trend. The control circuit may be configured to generate alarm information for warning the second risk level.

The control circuit may be configured to perform a protection operation for the battery cell according to a result of diagnosing the self-discharge state.

The protection operation may include at least one of a first operation of limiting an allowable charging/discharging condition including at least one of a temperature range, a state of charge (SOC) range, a voltage range, a maximum charge current or a maximum discharge current for the battery cell, a second operation of determining a recommended timing of a next rest period to be allocated to the battery cell, or a third operation of outputting a diagnostic message indicating the result of the diagnosis.

A battery pack according to another aspect of the present disclosure includes the battery diagnosis apparatus.

A battery system according to still another aspect of the present disclosure includes the battery diagnosis apparatus.

A battery diagnosis method according to yet another aspect of the present disclosure includes determining an amount of voltage drop of a battery cell for each rest period based on a voltage measurement signal collected at least twice every rest period, generating self-discharge history data indicating a change in the amount of voltage drop over the plurality of rest periods, and diagnosing a self-discharge state of the battery cell based on the self-discharge history data.

The diagnosing of the self-discharge state of the battery cell may include determining a first risk level arising from an increasing trend of the amount of voltage drop when the increasing trend is identified from the self-discharge history data.

The diagnosing of the self-discharge state of the battery cell may include determining a second risk level arising from a decreasing trend of the amount of voltage drop when the decreasing trend is identified from the self-discharge history data.

The battery diagnosis method may further include performing a protection operation for the battery cell according to a result of diagnosing the self-discharge state.

The protection operation may include at least one of a first operation of limiting an allowable charging/discharging condition including at least one of a temperature range, an SOC range, a voltage range, a maximum charge current or a maximum discharge current for the battery cell, a second operation of determining a recommended timing of a next rest period to be allocated to the battery cell, or a third operation of outputting a diagnostic message indicating the result of the diagnosis.

### Advantageous Effects

According to at least one of the embodiments of the present disclosure, the self-discharge state of the battery cell may be diagnosed by analyzing the self-discharge history data indicating a change in the amount of voltage drop of the battery cell over a plurality of rest periods sequentially allocated by periodically or aperiodically stopping the charge/discharge of the battery cell.

Additionally, according to at least one of the embodiments of the present disclosure, at least one of the increasing trend found primarily in the event of a severe internal short circuit of the battery cell or the decreasing trend found primarily in the event of excessive buildup of by-products of the battery cell may be identified from the self-discharge history data, and the differentiated protection operation for the battery cell may be performed depending on the identified trend among the increasing trend and the decreasing trend.

The effects of the present disclosure are not limited to the aforementioned effects, and these and other effects will be clearly understood by those skilled in the art from the appended claims.

### BRIEF DESCRIPTION OF THE DRAWINGS

The accompanying drawings illustrate exemplary embodiments of the present disclosure and together with the following detailed description, serve to provide a better understanding of the technical aspects of the present disclosure, and thus the present disclosure should not be construed as being limited to the drawings.
FIG. 1 is a diagram exemplarily showing the architecture of a battery system including a battery diagnosis apparatus according to the present disclosure.
FIGS. 2 and 3 are diagrams referenced in describing self-discharge of a battery cell.
FIG. 4 is a diagram referenced in describing an example of a time-dependent change of self-discharge state of a battery cell.
FIG. 5 is a diagram referenced in describing another example of a time-dependent change of self-discharge state of a battery cell.
FIG. 6 is a flowchart schematically showing a battery diagnosis method according to the present disclosure.
FIG. 7 is an exemplary flowchart illustrating sub-steps of step S630 included in the method of FIG. 6.
FIG. 8 is an exemplary flowchart illustrating sub-steps of step S640 included in the method of FIG. 6.

### BEST MODE

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, and rather, should be interpreted based on the meanings and concepts corresponding to the technical aspects of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspects of the present disclosure but not intended to be limiting, so it should be understood that a variety of other equivalents and modifications could have been made thereto at the time the application was filed.

The terms including the ordinal numbers such as "first", "second" and the like, are used to distinguish one element from another among various elements, but not intended to limit the elements by the terms.

Unless the context clearly indicates otherwise, the terms "comprise" and "include" when used in this specification, specify the presence of stated elements, but do not preclude the presence or addition of one or more other elements. Additionally, the term "unit" as used herein refers to a processing unit of at least one function or operation, and may be implemented by hardware and software either alone or in combination.

In addition, throughout this specification, it will be further understood that when an element is referred to as being "connected to" another element, it can be directly connected to the other element or intervening elements may be present.

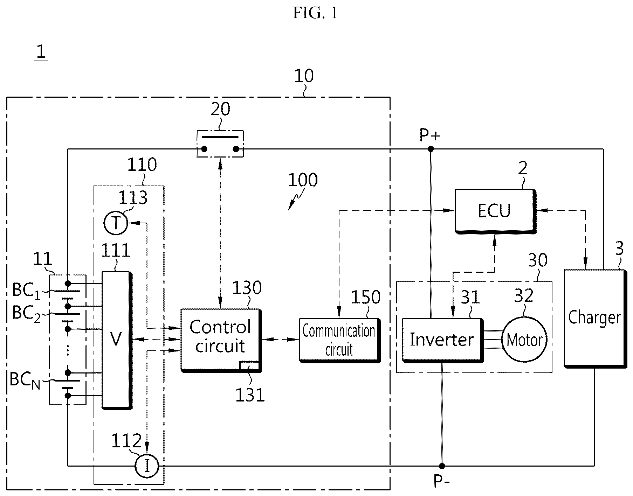

FIG. 1 is a diagram exemplarily showing the architecture of a battery system including a battery diagnosis apparatus according to the present disclosure.

Referring to FIG. 1, the battery system 1 includes a system controller 2, a battery pack 10, a relay 20 and an electrical load 30. Charge/discharge terminals P+, P- of the battery pack 10 may be electrically coupled to a charger 3 through a charging cable. The battery system 1 is not limited to a particular type, and may include, for example, any electrical system including a battery 11 as a power source such as an electric vehicle, or any electrical system intended to control and/or manage the state of the battery 11 from the outside such as a charging station.

The system controller 2 (for example, an Electronic Control Unit (ECU)) may be configured to transmit a key-on signal to a battery diagnosis apparatus 100 in response to a user's changing an operation button (not shown) of the battery system 1 to an ON-position. The system controller 2 may be configured to transmit a key-off signal to the battery diagnosis apparatus 100 in response to the user's changing the operation button to an OFF-position. The charger 3 may supply a charge power selected from constant power, constant current and constant voltage through the charge/discharge terminals P+, P- of the battery pack 10 via communication with the system controller 2.

The charge/discharge terminals P+, P- of the battery pack 10 may be electrically coupled to the electrical load 30 and/or the charger 3 through the power cable. The charger 3 may be included in the battery system 1 or may be present outside the battery system 1 so that it is attached or detached to/from the battery pack 10.

The battery pack 10 includes the battery 11. The battery 11 includes at least one battery cell BC. FIG. 1 shows the battery 11 including a plurality of battery cells BC₁~BC_{N} (N is a natural number of 2 or greater) connected in series by way of illustration. The plurality of battery cells BC₁~BC_{N} may be provided with the same electrochemical specification.

Hereinafter, in describing the common description of the plurality of battery cells BC₁~BC_{N}, the symbol 'BC' is affixed to the battery cell. The charger 3 may perform charge/discharge cycles needed to diagnose the battery cell BC through collaboration with an inverter 30 having a discharge function.

The battery cell BC includes a positive electrode and a negative electrode. The battery cell BC may include at least one unit cell as an electrochemical device that can be repeatedly charged and discharged. The battery cell BC is to be diagnosed by the battery diagnosis apparatus 100.

The relay 20 is electrically connected in series to the battery 11 through the power path connecting the battery 11 and the inverter 31. FIG. 1 shows the relay 20 connected between a positive terminal of the battery 11 and the charge/discharge terminal P+. The relay 20 is controlled to turn on/off in response to the switching signal from the battery diagnosis apparatus 100. The relay 20 may include a mechanical contactor that turns on or off by the magnetic force of a coil or a semiconductor switch such as Metal Oxide Semiconductor Field Effect transistor (MOSFET).

The electrical load 30 includes the inverter 31, and may further include the electric motor 32.

The inverter 31 is provided to convert direct current (DC) power from the battery 11 included in the battery pack 10 to alternating current (AC) power and/or DC power of a different voltage level in response to the command from the battery diagnosis apparatus 100 or the system controller 2.

The electric motor 32 operates using the AC power and/or the DC power supplied from the inverter 31. The electric motor 32 may include, for example, a 3-phase AC motor. The electrical load 30 may refer collectively to the components in the battery system 1 requiring the discharge power of the battery 11 including the inverter 31 and the electric motor 32.

The battery diagnosis apparatus 100 may be included in the battery pack 10. The battery diagnosis apparatus 100 includes a sensing unit 110 and a control circuit 130. The battery diagnosis apparatus 100 may further include a communication circuit 150.

The sensing unit 110 includes a voltage sensor 111. The sensing unit 110 may further include at least one of a current sensor 112 or a temperature sensor 113. The voltage sensor 111, the current sensor 112 and the temperature sensor 113 may generate a voltage measurement signal, a current measurement signal and a temperature measurement signal as described below, respectively.

The voltage sensor 111 is connected to the positive and negative terminals of the battery cell BC, and configured to detect a voltage (referred to as 'full cell voltage') across the battery cell BC, and generate the voltage measurement signal indicating a detection value of the detected voltage. The voltage sensor 111 may include one of known voltage detection devices such as a voltage measurement IC or a combination thereof.

The current sensor 112 may be connected in series to the battery 11 through the current path between the battery 11 and the inverter 31. The current sensor 112 is configured to detect the current (referred to as 'charge/discharge current') flowing through the battery 11, and generate the current measurement signal indicating a detection value of the detected current. Because the plurality of battery cells BC₁~BC_{N} is connected in series, the current flowing in the battery 11 is the same as the current flowing in the individual battery cell BC. The current sensor 112 may include one of known current detection devices such as a shunt resistor or a Hall-effect device or a combination thereof.

The temperature sensor 113 is attached to the outer surface of the battery cell BC or installed at a location near the battery cell BC and configured to detect a temperature of the battery cell BC, and generate the temperature measurement signal indicating a detection value of the detected temperature. The temperature sensor 113 may include one of known temperature detection devices such as a thermocouple, a thermistor or a bimetal, or a combination thereof.

The communication circuit 150 is configured to support wired or wireless communication between the control circuit 130 and the system controller 2. The wired communication may include, for example, controller area network (CAN) communication, and the wireless communication may include, for example, Zigbee or Bluetooth communication. The communication protocol may include any type of communication protocol that supports the wired/wireless communication between the control circuit 130 and the system controller 2 and is not limited to a particular one. The communication circuit 150 may include an output device (for example, a display, a speaker) to provide information received from the control circuit 130 and/or the system controller 2 into a recognizable format for the user (driver).

The control circuit 130 is operably coupled to the relay 20, the voltage sensor 111 and the communication circuit 150. Here, "operably coupled" refers to direct/indirect connection to enable signal transmission and reception in one or two directions.

The control circuit 130 may collect the voltage measurement signal from the voltage sensor 111, the current measurement signal from the current sensor 112 and/or the temperature measurement signal from the temperature sensor 113. The control circuit 130 may convert and record each analogue signal collected from the sensors 111, 112, 113 into a digital value by using an Analog to Digital Converter (ADC) equipped therein. Alternatively, at least one of the voltage sensor 111, the current sensor 112 or the temperature sensor 113 may include the ADC therein, and transmit the digital value output from the ADC to the control circuit 130.

The control circuit 130 may be also referred to as a 'battery controller' and be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing other functions.

The memory 131 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory 131 may store data and programs required for the computation operation by the control circuit 130. The memory 131 may store data indicating the results of the computation operation by the control circuit 130.

When the relay 20 is turned on, the battery 11 is in a charge mode or a discharge mode. When the relay 20 is turned off while the battery 11 is in use in the charge mode or the discharge mode, the battery 11 changes to a rest mode. In this specification, a rest period may refer to the time the battery 11 is in the rest mode.

The control circuit 130 may turn on the relay 20 in response to the key-on signal. The control circuit 130 may turn off the relay 20 in response to the key-off signal. The key-on signal is a signal that requests a change from rest to charge or discharge. The key-off signal is a signal that requests a change from charge or discharge to rest. Alternatively, instead of the control circuit 130, the system controller 2 may take responsibility for on-off control of the relay 20.

In this specification, measurement information (for example, time-series data) of a parameter may indicate a time-dependent change history of the parameter for a certain or specific period of time. Additionally, a profile (or a curve) indicating a correspondence relationship between two parameters acquired at a regular timing over the same period of time may be a polynomial equation acquired by mapping two measurement information of the two parameters to plot in the form of a 2-dimensional (2D) graph, or by applying a predetermined curve fitting logic to the set of two mapped measurement information. Here, the degree of the highest degree term of the polynomial equation may be preset.

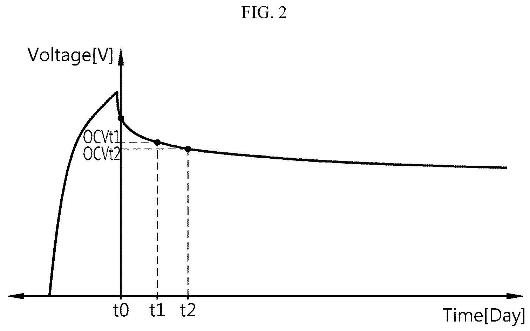

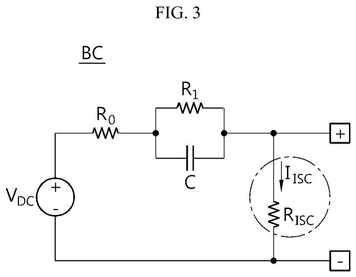

FIGS. 2 and 3 are diagrams referenced in describing the self-discharge of the battery cell. Specifically, FIG. 2 is a graph showing a time-dependent change of voltage in the battery cell by the change from charge to rest, and FIG. 3 is a diagram showing an exemplary equivalent circuit model of the battery cell.

First, referring to FIG. 2, t0 denotes the timing of change from charge to rest. That is, the time t0 may denote the start time of the rest period. Accordingly, in the range before the time t0, the voltage of the battery cell BC increases by the charge, and from the time t0, the voltage of the battery cell BC gradually decreases.

The time t0 may be the timing when the voltage of the battery cell BC reaches a predetermined reference voltage. Specifically, when the voltage of the battery cell BC is lower than the reference voltage, the control circuit 130 may transmit a charging request to the charger 3, and when the voltage of the battery cell BC reaches the reference voltage during charging of the battery cell BC, may transmit a charging stop request to the charger 3.

Ideally, during rest, the voltage of the battery cell BC only drops to a specific Open Circuit Voltage (OCV) corresponding to a State Of Charge (SOC) at the time t0. However, when a self-discharge failure exists in the battery cell BC, the voltage of the battery cell BC may be lower than the specific OCV even during rest due to the small amount of current flowing in the battery cell BC.

The control circuit 130 may measure the voltage of the battery cell BC at least twice and determine an amount of voltage drop for each rest period based on the measured voltage values every rest period. In FIG. 2, t1 denotes the first voltage measurement timing in a rest period, and t2 denotes the second voltage measurement timing in the same rest period. For example, a difference between the voltage value OCVₜ₁ measured at the time t1 and the voltage value OCVₜ₂ measured at the time t2 may be recorded in the memory 131 by the control circuit 130 as the amount of voltage drop in the corresponding rest period. The 'amount of voltage drop' as used herein may also be referred to as an 'amount of self - discharge'.

The time t1 may be the time after a stabilization time from the time t0. The stabilization time may be a preset time it takes for the battery cell BC to sufficiently settle after the rapid change in voltage by the change from charge to rest.

The time t2 may be the time after a stand-by time from the time t1. The stand-by time may be preset to determine the amount of voltage drop necessary to diagnose the self-discharge state. For example, the stabilization time may be 1 hour, and the stand-by time may be 1 day.

Subsequently, referring to FIG. 3, the equivalent circuit model of the battery cell BC may include a series circuit of a DC voltage source V_{DC}, an internal resistance component R₀ and an RC pair R₁, C. The RC pair R₁, C may be a parallel circuit of a resistance component R₁ and a capacitance component C. When a self-discharge failure exists, the equivalent circuit model includes an additional resistance component R_{ISC} connected between two ends of the series circuit. The additional resistance component R_{ISC} acts as a path of leakage current I_{ISC} that causes an internal short circuit-induced voltage drop. As the severity of the internal short circuit increases, the resistance value of the additional resistance component R_{ISC} decreases and the leakage current I_{ISC} increases, resulting in the increased amount of voltage drop.

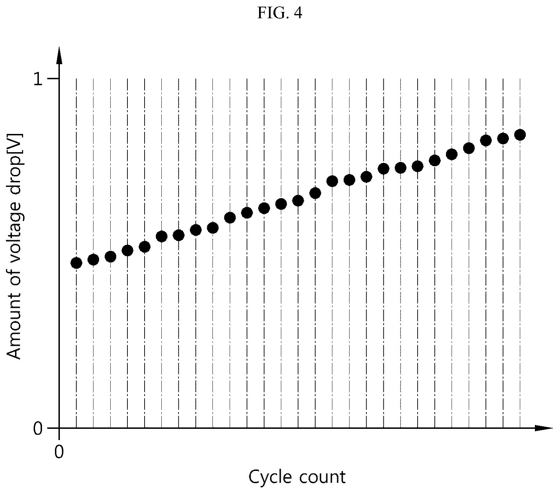

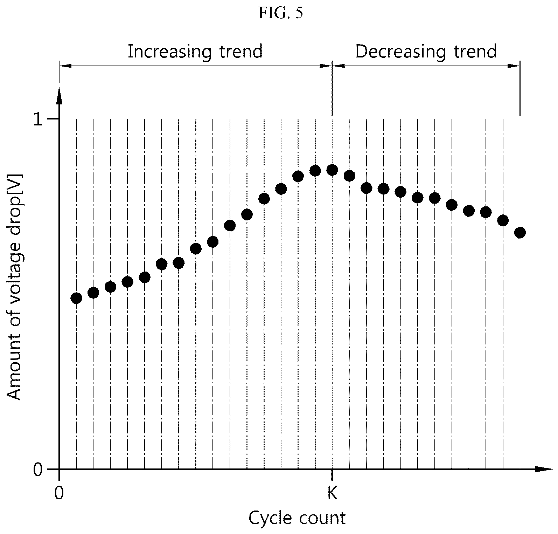

FIG. 4 is a diagram referenced in describing an example of a time-dependent change of self-discharge state of the battery cell, and FIG. 5 is a diagram referenced in describing another example of a time-dependent change of self-discharge state of the battery cell.

The graph shown in FIG. 4 shows a change history of the amount of voltage drop over the repeated first charge/discharge cycle, and the graph shown in FIG. 5 shows a change history of the amount of voltage drop over the repeated second charge/discharge cycle. More specifically, FIG. 4 is a 2D graph plotting self-discharge history data indicating a change in the amount of voltage drop over the repeated first charge/discharge cycle. The graph of FIG. 4 shows an increasing trend in which the amount of voltage drop continuously increases with the increasing cycle count. For reference, FIGS. 4 and 5 may be acquired from pre-experimental results of test battery cell(s) manufactured with the same specification as the battery cell BC.

In the graphs of FIGS. 4 and 5, the X axis indicates the cycle count and the Y axis indicates the amount of voltage drop.

The first charge-discharge cycle may include a procedure of charging the battery cell BC one time and discharging the battery cell BC one time between the upper limit and the lower limit of a first voltage range (for example, between 2.5V and 3.7V) in an environment where the outdoor air condition is controlled to a first reference temperature (for example, 25°C).

The second charge/discharge cycle may include a procedure of charging the battery cell BC one time and discharging the battery cell BC one time between the upper limit and the lower limit of a second voltage range (for example, between 2.5V and 4.2V) in an environment where the outdoor air condition is controlled to a second reference temperature (for example, 50°C) that is higher than the first reference temperature. That is, the second charge/discharge cycle may be a harsher charging/discharging procedure than the first charge/discharge cycle because high-voltage and high-temperature charge/discharge environment is created by the second charge/discharge cycle, compared to the first charge/discharge cycle.

Each charge/discharge cycle may include a charging procedure, a first resting procedure, a discharging procedure and a second resting procedure in a sequential order. Each charge/discharge cycle may further include a voltage tuning procedure between the charging procedure and the first resting procedure. The voltage tuning procedure may include applying constant voltage to match the OCV of the battery cell BC to the reference voltage.

The charging procedure of each of the first charge/discharge cycle and the second charge/discharge cycle may be performed according to Constant Current (CC)-Constant Voltage (CV) charging protocol. A first current rate may be used for the CC charging of the first charge/discharge cycle, and a second current rate may be used for the CC charging of the second charge/discharge cycle. The second current rate may be equal to or higher than the first current rate. The charging procedure of each of the first charge/discharge cycle and the second charge/discharge cycle may be performed according to CC-CV charging protocol. A third current rate may be used for the discharging procedure of the first charge/discharge cycle, and a fourth current rate may be used for the discharging procedure of the second charge/discharge cycle. The fourth current rate may be equal to or higher than the third current rate.

Each time one charge/discharge cycle is completed, the cycle count may increase by 1. The rest period may refer to a period of time during which the battery cell BC stops charging and discharging by the first resting procedure of the charge/discharge cycle. The control circuit 130 may determine the amount of voltage drop for each rest period. For reference, the second resting procedure is used to minimize polarization by the discharging procedure of the charge/discharge cycle in the same cycle number, and the battery cell BC stops charging and discharging for a predetermined time before the charging procedure of the next charge/discharge cycle.

FIG. 5 is a 2D graph plotting self-discharge history data indicating a change in the amount of voltage drop over the repeated second charge/discharge cycle. The front part of the graph of FIG. 5 is similar to the graph of FIG. 4 because of an increasing trend of voltage drop, but as opposed to the graph of FIG. 4, the amount of voltage drop changes from the increasing trend to a decreasing trend as the cycle count increases. In FIG. 5, the symbol K indicates the cycle count that identifies the change from the increasing trend to the decreasing trend in the change pattern of the amount of voltage drop.

For reference, the timing of the increasing-to-decreasing trend change may rely on the history of irregularly varying usage conditions (for example, the charge/discharge current, the charge/discharge voltage, the temperature and the main SOC range) over the whole life of the battery cell BC.

In many experiments, the inventors have found the tendency of the battery cell BC to degrade in the initial stage (Beginning of Life (BOL)) with a gradual increase in the amount of voltage drop during the rest period, stop increasing the amount of voltage drop at a certain point of time, and decrease in the amount of voltage drop from the Middle of Life (MOL).

Specifically, presumably, in the BOL, the path of small current in the battery cell BC may increase, resulting in the increased amount of voltage drop as shown in FIG. 4. After the battery cell BC further degrades in harsh conditions, in the MOL, by-products (for example, lithium metal deposits) accumulated on the electrode surface due to side reactions obstruct the flow of current through the path of small current between the positive electrode and the negative electrode, slowing down the self-discharge as shown in FIG. 5.

In addition, through many experimental results, the inventors have recognized a significant increase in the amount of gas generated in the battery cell BC on the basis of the change event from the increasing trend to the decreasing trend. Accordingly, to increase the safety and the life of the battery cell BC, it is necessary to change the control strategy for the battery cell BC depending on the identified trend among the increasing trend and the decreasing trend from the self-discharge history data.

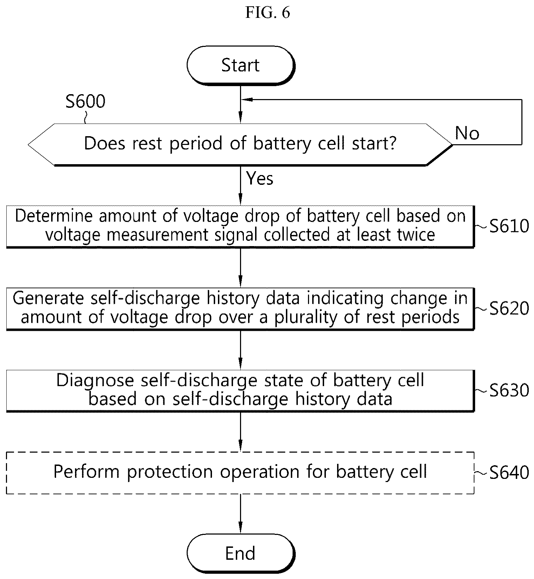

FIG. 6 is a flowchart schematically showing a battery diagnosis method according to the present disclosure. The method of FIG. 6 may be periodically performed in a repeated manner.

Referring to FIGS. 1 to 6, in step S600, the control circuit 130 may determine if the rest period of the battery cell BC has started. When a value of step S600 is "Yes", the method of FIG. 6 may move to step S610. When the value of step S600 is "No", the step S610 may be performed again or the method of FIG. 6 may end.

In the step S610, the control circuit 130 may determine the amount of voltage drop of the battery cell BC based on the voltage measurement signal collected at least twice from the sensing unit 110 during the rest period.

In step S620, the control circuit 130 may generate the self-discharge history data indicating a change in the amount of voltage drop over a plurality of rest periods.

Specifically, when the amount of voltage drop determined in the step S610 is an amount of voltage drop in an M-th rest period (M is a natural number of 2 or greater), the self-discharge history data generated in the step S620 may be a set of M amounts of voltage drop arranged in an order of time at which each amount of voltage drop is determined. For example, before the step S610 is performed, the self-discharge history data may include first to M-1th amounts of voltage drop, and when the M-th amount of voltage drop is determined by the step S610, the self-discharge history data may be updated to add the M-th amount of voltage drop in the step S620. By the update function in the step S620, the self-discharge history data may include the first to M-th amounts of voltage drop arranged in chronological order.

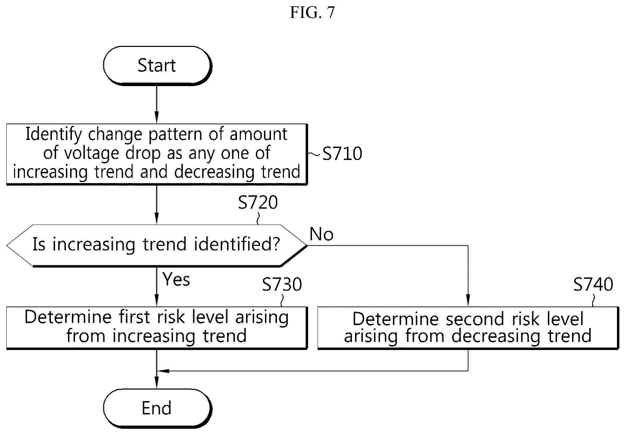

In step S630, the control circuit 130 diagnoses the self-discharge state of the battery cell BC based on the self-discharge history data. The detailed procedure of the step S630 will be described in more detail below with reference to FIG. 7.

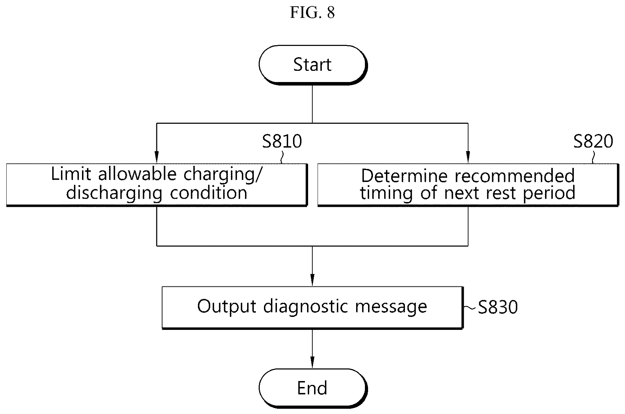

In step S640, the control circuit 130 performs the protection procedure for the battery cell BC based on the result of the diagnosis performed in the step S630. The step S640 is optional and may be omitted from the method of FIG. 6 where necessary. The detailed procedure of the step S640 will be described in more detail below with reference to FIG. 8.

FIG. 7 is an exemplary flowchart illustrating the sub-steps of the step S630 included in the method of FIG. 6.

Referring to FIG. 7, in step S710, the control circuit 130 may identify the change pattern of the amount of voltage drop over the plurality of rest periods as any one of the increasing trend and the decreasing trend from the self-discharge history data.

As an example, when the amount of current voltage drop (the amount of M-th voltage drop) is larger than the amount of previous voltage drop (the amount of M-1th voltage drop), the change pattern may be identified as the increasing trend, and otherwise, the change pattern may be identified as the decreasing trend.

As another example, when M is larger than u (preset as a natural number of 2 or greater), the control circuit 130 may determine an approximate straight line by applying the least squares method to data points indicating the amount of M-u-th voltage drop to the amount of M-th voltage drop. When the slope of the approximate straight line is positive, the change pattern may be identified as the increasing trend, and otherwise, the change pattern may be identified as the decreasing trend.

For reference, in general, the increasing trend precedes the decreasing trend, and considering this feature, the control circuit 130 may identify if the decreasing trend exists in the self-discharge history data, on the condition that the increasing trend has been identified before.

In step S720, the control circuit 130 may determine whether the increasing trend was identified in the step S710. When a value of step S720 is "Yes", step S730 may be performed. The value of step S720 being "No" represents that the decreasing trend was identified in the step S710, and in this case, step S740 may be performed.

In the step S730, the control circuit 130 may determine a first risk level arising from the increasing trend. The first risk level may be a type of diagnostic parameter indicating the likelihood or severity level of the internal short circuit described above with reference to FIG. 3.

The control circuit 130 may determine the first risk level according to the intensity of the increasing trend. The intensity of the increasing trend may include a difference between the amount of current voltage drop (the amount of M-th voltage drop) and the mount of previous voltage drop (the amount of M-1th voltage drop) and/or the absolute value of the slope of the approximate straight line.

In step S740, the control circuit 130 may determine a second risk level arising from the decreasing trend. The second risk level may be a type of diagnostic parameter indicating the likelihood or severity of excessive gas generation described above with reference to FIG. 5.

The control circuit 130 may determine the second risk level according to the intensity of the decreasing trend. The intensity of the decreasing trend may include the difference between the amount of current voltage drop (the amount of M-th voltage drop) and the amount of previous voltage drop (the amount of M-1th voltage drop) and/or the absolute value of the slope of the approximate straight line.

FIG. 8 is an exemplary flowchart illustrating the sub-steps of the step S640 included in the method of FIG. 6.

Referring to FIG. 8, in step S810, the control circuit 130 may perform a first operation of limiting an allowable charging/discharging condition including at least one of a temperature range, a SOC range, a voltage range, a maximum charge current or a maximum discharge current for the battery cell BC according to the result of diagnosing the self-discharge state of the battery cell BC.

First relationship data between the limit amount of the allowable charging/discharging condition and the first risk level and second relationship data between the limit amount of the allowable charging/discharging condition and the second risk level may be recorded in the memory 131.

The control circuit 130 may perform the first operation by referring to the first relationship data when the increasing trend is identified, and may perform the first operation by referring to the second relationship data when the decreasing trend is identified.

For example, as the second risk level increases, the upper limit of at least one of the temperature range, the SOC range or the voltage range allowed for the battery cell BC may be lowered. In particular, when the upper limit of the temperature is lowered by the first operation performed in response to the decreasing trend being identified, technical effects of slowing down gas generation and significantly reducing fire or explosion risks may be expected.

The decreasing trend is a strong indication of a very large amount of gas generated in the battery cell BC, and the large amount of gas accumulated in the battery cell BC may easily cause an explosion of the battery cell BC, so the decreasing trend manifests a higher level of danger than the increasing trend. Accordingly, when the intensity of the decreasing trend and the intensity of the increasing trend are equal, the limit amount of the allowable charging/discharging condition according to the second relationship data may be set to be larger than the limit amount of allowable charging/discharging condition according to the first relationship data by a predetermined value.

In step S820, the control circuit 130 may perform a second operation of determining a recommended timing of the next rest period to be allocated to the battery cell BC. Third relationship data between the allowable period and the first risk level and fourth relationship data between the allowable period and the second risk level may be recorded in the memory 131.

The control circuit 130 may determine the allowable period by referring to the third relationship data when the increasing trend is identified, and may determine the allowable period by referring to the fourth relationship data when the decreasing trend is identified. Subsequently, the control circuit 130 may determine the time after the allowable period from the present time as the recommended timing of the next rest period. For example, as the second risk level is higher, the recommended timing of the next rest period may be earlier.

When the recommended period is reached, the user of the battery system 1 may be encouraged to allocate the rest period to diagnose the self-discharge state again.

In step S830, the control circuit 130 may perform a third operation of outputting a diagnostic message indicating the result of diagnosing the self-discharge state of the battery cell BC. The diagnostic message may include information indicating at least one of the charging/discharging condition limited by the first operation or the recommended timing determined by the second operation. The diagnostic message may include alarm information for notifying the first risk level or the second risk level.

The diagnostic message may be transmitted from the control circuit 130 to the system controller 2 through the communication circuit 150. The system controller 2 may control the information output device (not shown) of the battery system 1 to visually and/or audibly output the information contained in the diagnostic message to the user.

Any one or two of the steps S810, S820 and S830 may be omitted from the method of FIG. 8. In addition, an order in which the steps S810, S820, and S830 are performed is not limited to the example of FIG. 8. As an example, the step S810 may be performed after the step S820 is performed. As another example, when the steps S810 and S820 are omitted from the method of FIG. 8, the step S830 may be performed immediately after the end of the step S630.

The embodiments of the present disclosure as described above are not embodied only through an apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to certain embodiments and drawings, the present disclosure is not limited thereto and it is obvious to those skilled in the art that various modifications and changes may be made thereto within the technical aspects of the present disclosure and the scope of the appended claims and their equivalents.

Additionally, as many substitutions, modifications and changes may be made to the present disclosure as described above by those skilled in the art without departing from the technical aspects of the present disclosure, the present disclosure is not limited by the above-described embodiments and the accompanying drawings, and some or all of the embodiments may be selectively combined to allow various modifications.

## Claims

1. A battery diagnosis apparatus comprising:
a sensing unit configured to measure a voltage of a battery cell; and
a control circuit configured to determine an amount of voltage drop of the battery cell for each rest period based on a voltage measurement signal collected from the sensing unit at least twice every rest period,
wherein the control circuit is configured to:
generate self-discharge history data indicating a change in the amount of voltage drop over the plurality of rest periods, and
diagnose a self-discharge state of the battery cell based on the self-discharge history data.

2. The battery diagnosis apparatus according to claim 1,
wherein the control circuit is configured to:
determine a first risk level arising from an increasing trend of the amount of voltage drop when the increasing trend is identified from the self-discharge history data.

3. The battery diagnosis apparatus according to claim 2,
wherein the control circuit is configured to:
determine the first risk level according to an intensity of the increasing trend, and
generate alarm information for warning the first risk level.

4. The battery diagnosis apparatus according to claim 1,
wherein the control circuit is configured to:
determine a second risk level arising from a decreasing trend of the amount of voltage drop when the decreasing trend is identified from the self-discharge history data.

5. The battery diagnosis apparatus according to claim 4,
wherein the control circuit is configured to:
determine the second risk level according to an intensity of the decreasing trend, and
generate alarm information for warning the second risk level.

6. The battery diagnosis apparatus according to claim 1,
wherein the control circuit is configured to:
perform a protection operation for the battery cell according to a result of diagnosing the self-discharge state.

7. The battery diagnosis apparatus according to claim 6,
wherein the protection operation includes at least one of:
a first operation of limiting an allowable charging/discharging condition including at least one of a temperature range, a state of charge (SOC) range, a voltage range, a maximum charge current or a maximum discharge current for the battery cell;
a second operation of determining a recommended timing of a next rest period to be allocated to the battery cell; or
a third operation of outputting a diagnostic message indicating the result of the diagnosis.

8. A battery pack comprising the battery diagnosis apparatus according to any one of claims 1 to 7.

9. A battery system comprising the battery diagnosis apparatus according to any one of claims 1 to 7.

10. A battery diagnosis method comprising:
determining an amount of voltage drop of a battery cell for each rest period based on a voltage measurement signal collected at least twice every rest period;
generating self-discharge history data indicating a change in the amount of voltage drop over the plurality of rest periods; and
diagnosing a self-discharge state of the battery cell based on the self-discharge history data.

11. The battery diagnosis method according to claim 10,
wherein the diagnosing of the self-discharge state of the battery cell comprises:
determining a first risk level arising from an increasing trend of the amount of voltage drop when the increasing trend is identified from the self-discharge history data.

12. The battery diagnosis method according to claim 10,
wherein the diagnosing of the self-discharge state of the battery cell comprises:
determining a second risk level arising from a decreasing trend of the amount of voltage drop when the decreasing trend is identified from the self-discharge history data.

13. The battery diagnosis method according to claim 10, further comprising:
performing a protection operation for the battery cell according to a result of diagnosing the self-discharge state.

14. The battery diagnosis method according to claim 13,
wherein the protection operation includes at least one of:
a first operation of limiting an allowable charging/discharging condition including at least one of a temperature range, a state of charge (SOC) range, a voltage range, a maximum charge current or a maximum discharge current for the battery cell;
a second operation of determining a recommended timing of a next rest period to be allocated to the battery cell; or
a third operation of outputting a diagnostic message indicating the result of the diagnosis.
